# EUROPEAN PATENT APPLICATION

(11) **EP 2 669 348 A1**
(43) Date of publication of application: **04.12.2013**
(21) Application number: 12739396.5
(22) Date of filing: 11.01.2012
(51) Int. Cl.: C09J 163/00, C09J 9/02, C09J 11/04, C09J 11/06, H01B 1/22, H01L 31/042

(54) **CONDUCTIVE BINDER COMPOSITION, METAL WIRE WITH CONDUCTIVE BINDER, BONDED UNIT, AND SOLAR CELL MODULE**

(30) Priority: 27.01.2011 JP 2011015624
(71) Applicant: Hitachi Chemical Company, Ltd., Chiyoda-ku Tokyo 100-6606 (JP)
(72) Inventor: YOKOCHI Seigo, Hitachi-shi Ibaraki 317-8555 (JP); FUJITA Masaru, Hitachi-shi Ibaraki 317-8555 (JP); HAYASHI Hiroki, Tsukuba-shi Ibaraki 300-4247 (JP)
(74) Representative: Albrecht, Thomas
(86) International application number: PCT/JP2012/050361
(87) International publication number: WO 2012/102076

(57) **Abstract**

Provided is a conductive adhesive composition including: conductive particles (A) containing metal having a melting point of equal to or lower than 210°C; a resin (B) having a softening point of equal to or lower than the melting point of the metal of the conductive particles and being solid at a room temperature; a flux activator (C); and a solvent (D).

## Description

### Technical Field

The present invention relates to a conductive adhesive composition and a metal wire with a conductive adhesive which are suitably used for electric connection of a plurality of solar battery cells, a connected body using the same, and a solar cell module.

### Background Art

As means for solving aggravated global warming or fossil energy depletion, attention is paid on a solar battery which is a power generating system using sunlight. A structure in which solar battery cells in which an electrode is formed on a monocrystalline or polycrystalline Si wafer, are connected in series or in parallel to each other via a metal wire, has been employed for the current main solar battery cells. In general, solder which shows excellent conductivity and is inexpensive has been used for the connection of the electrodes of the solar battery cells and the metal wire (Patent Literature 1). Further, in recent years, in consideration of environmental problems, a method has been known for applying Sn-Ag-Cu solder which does not contain Pb onto a copper wire which is a metal wire, and connecting electrodes of solar battery cells and the metal wire by performing heating to a temperature equal to or higher than a melting temperature of the solder (Patent Literature 1 and 2).

However, at the time of the connecting, since it is necessary to perform heating at a temperature equal to or higher than 260°C which exceeds a melting point of the Sn-Ag-Cu solder, in addition to an occurrence of property degradation of the solar battery cells, there are problems that warping or cracking of solar battery cells is generated and yield ratio is degraded.

For solving such problems, a use of a conductive adhesive composition capable of electrical connection at a lower temperature has been proposed (Patent Literature 3). This conductive adhesive composition is a composition obtained by mixing and dispersing of metal particles which are typified by silver particles in a thermosetting resin, and the electrical connection is expressed by physical contacting with these metal particles to the electrodes of the solar battery cells and the metal wire.

In addition, an adhesive which contains a thermosetting resin as an alternative material of the solder, metal particles such as lead-free solder melting at a low temperature and flux, and has a low melting temperature, excellent wettability, and high binding strength has been proposed (Patent Literature 4).

### Citation List

### Patent Literature

[Patent Literature 1] Japanese Unexamined Patent Application Publication No. 2002-263880
[Patent Literature 2] Japanese Unexamined Patent Application Publication No. 2004-204256
[Patent Literature 3] Japanese Unexamined Patent Application Publication No. 2005-243935
[Patent Literature 4] Japanese Unexamined Patent Application Publication No. 2004-160508

### Summary of Invention

### Technical Problem

However, since the conductivity expressing mechanism of the conductive adhesive composition disclosed in Patent Literature 3 is realized based on the contact of metal particles, it is necessary to increase content of the metal particles for securing excellent conductivity. As a result, adhesiveness of the adhesive is degraded according to the reduction of the adhesive components.

In addition, in a case of using the conductive adhesive composition disclosed in Patent Literature 4 for producing a solar cell module, the present inventors have found that there is a problem that it is difficult to handle the conductive adhesive composition, since the adhesive has tackiness.

Herein, an object of the present invention is to provide a conductive adhesive composition which does not have tackiness at a room temperature and is capable of electrical connection at a low temperature, and a metal wire with a conductive adhesive using the composition. In addition, another object thereof is to provide a connected body and a solar cell module using the conductive adhesive composition or the metal wire with a conductive adhesive.
In addition, in the present specification, the phrase of "does not have tackiness" means that the tackiness is not recognized as a result of a predetermined test disclosed in Examples.

### Solution to Problem

The present invention provides a conductive adhesive composition including: conductive particles (A) containing metal having a melting point of equal to or lower than 210°C (hereinafter, also simply referred to as "conductive particles (A)"); a resin (B) having a softening point of equal to or lower than the melting point of the metal of the conductive particles and being solid at a room temperature (hereinafter, also simply referred to as a "resin (B)"); a flux activator (C); and a solvent (D).

According to the conductive adhesive composition, by employing the configuration described above, it is possible to avoid the tackiness at a room temperature and to perform electrical connection at a low temperature.

In addition, in the present specification, the "melting point" refers to a value measured by Differential Scanning Calorimetry (DSC), for example, and the "softening point" refers to a value measured by a rheometer which can change a measurement temperature, for example.

It is preferable that the metal of the conductive particles (A) contain at least one kind of component selected from bismuth, indium, tin, and zinc. Accordingly, it is possible to decrease the melting point of the conductive particles while maintaining excellent conductivity.

From a viewpoint of obtaining excellent connection stability, it is preferable that the resin (B) contain a thermosetting resin, and particularly contain an epoxy resin.

In a case where the conductive adhesive composition described above contains the thermosetting resin, it is preferable that the conductive adhesive composition further contain a curing agent or a curing accelerator.

It is preferable that the flux activator (C) contain a compound having a hydroxy group and a carboxyl group.

It is preferable that a boiling point of the solvent (D) be equal to or higher than 20°C and equal to or lower than 300°C. Accordingly, it becomes easy to remove the solvent and it is possible to apply the conductive adhesive composition evenly on the electrode surfaces of the solar battery cells.

The conductive adhesive composition described above may be suitably used for electrical connection of the electrodes of the solar battery cells and the metal wire.

In addition, the present invention provides a connected body in which a plurality of solar battery cells are connected via a metal wire, in which electrodes of the solar battery cells and the metal wire are connected via the conductive adhesive composition described above.

In addition, the present invention provides a metal wire with a conductive adhesive formed of a metal wire and an adhesive layer coating the metal wire, in which the adhesive layer is formed of an adhesive using the conductive adhesive composition described above.

In addition, the present invention provides a connected body formed of a plurality of solar battery cells, and a metal wire with a conductive adhesive which is disposed on electrode surfaces of the solar battery cells and is for electrical connection of the plurality of solar battery cells, in which the metal wire with a conductive adhesive is the metal wire with a conductive adhesive described above.

In addition, the present invention provides a method for producing a solar cell module including: a step of laminating a sealing material on both surfaces of the connected body described above; a step of laminating glass on the sealing material on a light receiving surface side of the solar battery cells, and a protection film on the sealing material on a rear surface of the solar battery cells; and a step of sealing the solar battery cells while electrically connecting and bonding the solar battery cells and the metal wires by heating the obtained laminated body.

In addition, the present invention provides a solar cell module in which electrodes of a plurality of solar battery cells and metal wire are electrically connected to via the conductive adhesive composition described above.

### Advantageous Effects of Invention

According to the present invention, it is possible to provide a conductive adhesive composition which does not have tackiness at a room temperature and is capable of electrical connection at a low temperature, and the metal wire with a conductive adhesive using the composition. In addition, by using the conductive adhesive composition or the metal wire with a conductive adhesive, it is possible to provide a connected body which realizes shortening and simplicity of process at the time of producing the solar cell module. Further, by using the conductive adhesive composition which is capable of electrical connection at a low temperature or the metal wire with a conductive adhesive, it is possible to provide a solar cell module having high reliability.

### Brief Description of Drawings

Fig. 1 is a schematic view showing main parts of a solar cell module according to the present invention.
Fig. 2 is a view for illustrating one embodiment of a method for producing a solar cell module according to the present invention.

### Description of Embodiments

Hereinafter, preferred embodiments of the present invention will be described in detail with reference to the drawings. In addition, in the drawings, the same reference numerals are given to the same or corresponding parts, and the overlapping description is omitted.

A conductive adhesive composition of the present invention contains conductive particles (A), a resin (B), a flux activator (C), and a solvent (D).

As the conductive particles (A), particles which contain metal having a melting point of equal to or lower than 210°C, more preferably particles which contain metal having a melting point of equal to or lower than 200°C can be used. The lower limit of the melting point of the metal of the conductive particles (A) is not particularly limited, however, it is usually about 120°C. If such conductive particles are used for the conductive adhesive composition, it is considered that the conductive particles are melted at a relatively low temperature, that is, a plurality of melted conductive particles (A) are assembled for integration, and the integrated fused body electrically connects target objects directly.

In consideration of environmental problems, the metal of the conductive particles (A) is preferably constituted from metal other than lead. An example of the metal constituting the conductive particles (A) includes a simple substance or alloy containing at least one kind of component selected from tin (Sn), bismuth (Bi), indium (In), and zinc (Zn). In addition, from a viewpoint of obtaining further excellent connection reliability, the alloy can contain high-melting-point components selected from Pt, Au, Ag, Cu, Ni, Pd, Al, and the like, in a range where melting point of the entire metal of the conductive particles (A) is 210°C.

Specifically, as the metal constituting the conductive particles (A), Sn42-Bi58 solder (melting point of 138°C), Sn48-In52 solder (melting point of 117°C), Sn42-Bi57-Ag1 solder (melting point of 139°C), Sn90-Ag2-Cu0.5-Bi7.5 solder (melting point of 189°C), Sn96-Zn8-Bi3 solder (melting point of 190°C), Sn91-Zn9 solder (melting point of 197°C), and the like are preferable since they show a clear solidification behavior after melting. The solidification behavior is a behavior of the metal being cooled and solidified again after being melted. Among these, from a view point of availability or a low melting point, Sn-42-Bi58 solder or Sn42-Bi57-Ag1 solder are preferably used. Those are used alone as one kind, or in combination of two or more kinds.

An average particle size of the conductive particles (A) is not particularly limited, however, is preferably 0.1 to 100 µm. If this average particle size thereof is less than 0.1 µm, the viscosity of the conductive adhesive composition tends to be increased, and the workability tends to be decreased. In addition, if the average particle size of the conductive particles exceeds 100 µm, printing performance and connection reliability tend to be degraded. From a viewpoint of obtaining even more excellent printing performance and workability of the conductive adhesive composition, the average particle size thereof is more preferably 1.0 to 50 µm. In addition, from a viewpoint of further improving preservation stability of the conductive adhesive composition and mounting reliability of a cured product, the average particle size thereof is particularly preferably 5.0 to 30 µm. Herein, the average particle size is a value measured by a laser diffraction and scattering method (Kamioka Mining Test Method No.2).

In addition to the particles constituted of only the metal having the melting point of equal to or lower than 210°C, the conductive particles (A) may be conductive particles obtained by coating surfaces of particles consisting of solid-state materials other than metal such as ceramics, silica, and resin materials, with a metal film consisting of metal having a melting point of equal to or lower than 210°C, or may be a mixture thereof.

In the content of the conductive particles (A) of the conductive adhesive composition, content of metal constituting the conductive particles thereof is preferably 5 to 95% by mass with respect to the total amount of the conductive adhesive composition. In a case where the content of the metal is less than 5% by mass, the conductivity of the cured product of the conductive adhesive composition tends to be degraded. On the other hand, if the content of the metal exceeds 95% by mass, the viscosity of the conductive adhesive composition is increased and the workability is decreased. In addition, since the adhesive components in the conductive adhesive composition are relatively decreased, the mounting reliability of the cured product tends to be decreased.

From a viewpoint of improving the workability or conductivity, the content of the metal with respect to the total amount of conductive adhesive composition is more preferably 10 to 90% by mass, and from a viewpoint of improving the mounting reliability of the cured product, the content thereof is even more preferably 15 to 85% by mass, and particularly preferably 50 to 85% by mass.

In addition, conductive particles (a1) consisting of metal having a melting point of higher than 210°C may be used with the conductive particles (A). An example of such metal having a melting point of higher than 210°C includes one kind of metal or alloy consisting of two or more kinds of metal selected from Pt, Au, Ag, Cu, Ni, Pd, Al, and the like, and more specifically, the examples thereof include Au powder, Ag powder, Cu powder, Ag-plated Cu powder. As a commercially available product, "MA05K" (product name, manufactured by Hitachi Chemical Co., Ltd.) which is silver-plated copper powder.

In a case of using the conductive particles (a1) consisting of metal having the melting point of higher than 210°C with the conductive particles (A), a combination ratio thereof is preferably in a range where (A) : (a1) is 99:1 to 50:50 by mass ratio, and more preferably in a range where (A) : (a1) is 99:1 to 60:40.

The resin (B) is a resin having a softening point equal to or lower than the melting point of the metal of the conductive particles (A) and is solid at a room temperature. Since such a resin becomes liquid at a room temperature equal to or lower than the melting point at the time of heating, fusion of the conductive particles (A) is not avoidable. Herein, the room temperature is 20°C. By using such a resin, it is possible to avoid tackiness. If the softening point of the applied resin exceeds 210°C, it is difficult for the particles to be fused at the time of melting of the metal. In addition, in a case where the softening point of the resin is too low, cracks or peeling-off occurs in the coating film after the coating of the metal wire, in some cases, and tackiness remains and the conductive adhesive composition tends to be difficult to be handled. The softening point of the resin (B) is equal to or lower than 210°C, however, is more preferably equal to or higher than 0°C and equal to or lower than 180°C. In addition, the softening point thereof is even more preferably equal to or higher than 30°C and equal to or lower than 150°C. Further, the softening point thereof is particularly preferably equal to or higher than 80°C and equal to or lower than 150°C.

The resin (B) performs an act of bonding a coated object thereof, and functions as a binder component which binds the conductive particles in the conductive adhesive composition and a filler which is added if necessary to each other. Examples of such a resin include a thermosetting organic polymer compound such as an epoxy resin, a (meth)acrylic resin, a maleimide resin, and a cyanate resin, and a precursor thereof. Herein, the (meth)acrylic resin denotes a methacrylic resin and an acrylic resin. Among these, a compound having polymerizable carbon-carbon double bond which is polymerizable represented by the (meth)acrylic resin and the maleimide resin, or the epoxy resin is preferable. These thermosetting resins described above are excellent in heat resistance and the adhesiveness, and also, since the resins can be used in a liquid state if they are dissolved or dispersed in an organic solvent if necessary, they are also excellent in workability. The thermosetting resin described above is used alone as one kind, or in combination of two or more kinds.

The (meth)acrylic resin is configured from the compound having polymerizable carbon-carbon double bond. Examples of the compound include a monoacrylate compound, a monomethacrylate compound, a diacrylate compound, and a dimethacrylate compound.

Examples of the monoacrylate compound include methyl acrylate, ethyl acrylate, n-propyl acrylate, isopropyl acrylate, n-butyl acrylate, isobutyl acrylate, t-butyl acrylate, amyl acrylate, isoamyl acrylate, hexyl acrylate, heptyl acrylate, octyl acrylate, 2-ethylhexyl acrylate, nonyl acrylate, decyl acrylate, isodecyl acrylate, lauryl acrylate, tridecyl acrylate, hexadecyl acrylate, stearyl acrylate, isostearyl acrylate, cyclohexyl acrylate, isobornyl acrylate, diethylene glycol acrylate, polyethylene glycol acrylate, polypropylene glycol acrylate, 2-methoxyethyl acrylate, 2-ethoxyethyl acrylate, 2-butoxyethyl acrylate, methoxy diethylene glycol acrylate, methoxy polyethylene glycol acrylate, dicyclopentenyloxyethyl acrylate, 2-phenoxyethyl acrylate, phenoxy diethylene glycol acrylate, phenoxy polyethylene glycol acrylate, 2-benzoyloxyethyl acrylate, 2-hydroxy-3-phenoxypropyl acrylate, benzyl acrylate, 2-cyanoethyl acrylate, γ-acryloxyethyl trimethoxysilane, glycidyl acrylate, tetrahydrofurfuryl acrylate, dimethylaminoethyl acrylate, diethylaminoethyl acrylate, acryloxyethyl phosphate, and acryloxyethyl phenyl acid phosphate.

Examples of the monomethacrylate compound include methyl methacrylate, ethyl methacrylate, propyl methacrylate, isopropyl methacrylate, n-butyl methacrylate, isobutyl methacrylate, t-butyl methacrylate, amyl methacrylate, isoamyl methacrylate, hexyl methacrylate, heptyl methacrylate, octyl methacrylate, 2-ethylhexyl methacrylate, nonyl methacrylate, decyl methacrylate, iso-decyl methacrylate, lauryl methacrylate, tridecyl methacrylate, hexadecyl methacrylate, stearyl methacrylate, isostearyl methacrylate, cyclohexyl methacrylate, isobornyl methacrylate, diethylene glycol methacrylate, polyethylene glycol methacrylate, polypropylene glycol methacrylate, 2-methoxyethyl methacrylate, 2-ethoxyethyl methacrylate, 2-butoxyethyl methacrylate, methoxy diethylene glycol methacrylate, methoxy polyethylene glycol methacrylate, dicyclopentenyloxyethyl methacrylate, 2-phenoxyethyl methacrylate, phenoxydiethylene glycol methacrylate, phenoxypolyethylene glycol methacrylate, 2-benzoyloxyethyl methacrylate, 2-hydroxy-3-phenoxypropyl methacrylate, benzyl methacrylate, 2-cyanoethyl methacrylate, γ-methacryloxyethyl trimethoxysilane, glycidyl methacrylate, tetrahydrofurfuryl methacrylate, dimethylaminoethyl methacrylate, diethylaminoethyl methacrylate, methacryloxyethyl phosphate, and methacryloxyethylphenyl acid phosphate.

Examples of the diacrylate compound include ethylene glycol diacrylate, 1,4-butanediol diacrylate, 1,6-hexanediol diacrylate, 1,9-nonane diol diacrylate, 1,3-butanediol diacrylate, neopentyl glycol diacrylate, diethylene glycol diacrylate, triethylene glycol diacrylate, tetraethylene glycol diacrylate, polyethylene glycol diacrylate, tripropylene glycol diacrylate, polypropylene glycol diacrylate, a resultant os reaction between 1 mole of bisphenol A, bisphenol F, or bisphenol AD and 2 moles of glycidyl acrylate, diacrylate of a polyethylene oxide adduct of bisphenol A, bisphenol F, or bisphenol AD, diacrylate of a polypropylene oxide adduct of bisphenol A, bisphenol F, or bisphenol AD, bis(acryloxypropyl)polydimethylsiloxane, and a bis(acryloxypropyl)methylsiloxane-dimethylsiloxane copolymer.

Examples of the dimethacrylate compound include ethylene glycol dimethacrylate, 1,4-butanediol dimethacrylate, 1,6-hexanediol dimethacrylate, 1,9-nonanediol dimethacrylate, 1,3-butanediol dimethacrylate, neopentyl glycol dimethacrylate, diethylene glycol dimethacrylate, triethylene glycol dimethacrylate, tetraethylene glycol dimethacrylate, polyethylene glycol dimethacrylate, tripropylene glycol dimethacrylate, polypropylene glycol dimethacrylate, a resultant of reaction between 1 mole of bisphenol A, bisphenol F, or bisphenol AD, and 2 moles of glycidyl methacrylate, dimethacrylate of a polyethylene oxide adduct of bisphenol A, bisphenol F, or bisphenol AD, a polypropylene oxide adduct of bisphenol F or bisphenol AD, bis(methacryloxypropyl)polydimethylsiloxane, and a bis(methacryloxypropyl)methylsiloxane-dimethylsiloxane copolymer.

These compounds are used alone as one kind, or in combination of two or more kinds. In addition, when containing the (meth)acrylic resin as the thermosetting resin, these compound may be used after performing polymerization in advance, or the compounds may be mixed with the conductive particles (A), the flux activator (C), and the solvent (D) and polymerization may be performed at the same time as the mixing.

When the thermosetting resin is configured from the compound having polymerizable carbon-carbon double bond, the conductive adhesive composition preferably contains a radical polymerization initiator. From a viewpoint of efficiently suppressing voids, organic peroxide is suitable for the radical polymerization initiator. In addition, from a viewpoint of improving curing property and viscosity stability of the conductive adhesive composition, a decomposition temperature of the organic peroxide is preferably 70 to 170°C, and more preferably 80 to 160°C.

Examples of the radical polymerization initiator include 1,1,3,3,-tetramethylbutylperoxy2-ethylhexanoate, 1,1-bis(t-butylperoxy)cyclohexane, 1,1-bis(t-butylperoxy)cyclododecane, di-t-butylperoxyisophthalate, t-butylperoxybenzoate, dicumyl peroxide, t-butylcumyl peroxide, 2,5-dimethyl-2,5-di-(t-butylperoxy)hexane, 2,5-dimethyl-2,5-di-(t-butylperoxy)-3-hexyne, and cumene hydroperoxide. These may be used alone as one kind or in combination of two or more kinds.

A combination rate of the radical polymerization initiator is preferably 0.01 to 20% by mass, more preferably 0.1 to 10% by mass, and even more preferably 0.5 to 5% by mass, with respect to the total amount of the components other than the conductive particles and solvent of the conductive adhesive composition (hereinafter, referred to as a "adhesive component").

A commercially available resin can be used for the acrylic resin. Specific Examples thereof include FINEDIC A-261 (product name, manufactured by DIC Corporation, softening point: 105 ± 3°C), FINEDIC A-229-30 (product name, manufactured by DIC Corporation, softening point: 109 ± 3°C), and the like.

The epoxy resin is not particularly limited as long as it is a compound having two or more epoxy groups in one molecule thereof, and well-known compounds can be used. Examples of the epoxy resin include a condensation product of bisphenol A, bisphenol AD, bisphenol S, bisphenol F, or halogenated bisphenol A, and epichlorohydrin, glycidyl ether of a phenol novolac resin, glycidyl ether of a cresol novolac resin, and glycidyl ether of a bisphenol A novolac resin.

A commercially available product can be used for the epoxy resin. Specific examples thereof include Epikote 1004 (softening point of 97°C), 1004AF (softening point of 97°C), and 1007 (softening point of 128°C) (product names, all manufactured by Mitsubishi Chemical Corporation), YD-012 (softening point of 75 to 85°C), YD-013 (softening point of 85 to 98°C), and YD-014 (softening point of 91 to 102°C) (product names, all manufactured by NIPPON STEEL & SUMIKIN CHEMICAL CO., LTD.), EPICLON 4050 (softening point of 96 to 104°C) and EPICLON 7050 (softening point of 1.22 to 131°C) (product names, all manufactured by DIC Corporation) which are bisphenol A-type epoxy resins, Epikote 4005P (softening point of 87°C) and 4007P (softening point of 108°C) (product names, all manufactured by Mitsubishi Chemical Corporation), and YDF-2005RL (softening point of 91 to 96°C) (product name, manufactured by NIPPON STEEL & SUMIKIN CHEMICAL CO., LTD.) which are bisphenol F-type epoxy resins, Epikote YX4000 (softening point of 105°C) (product name, manufactured by Mitsubishi Chemical Corporation) which is a biphenyl-type epoxy resin, EPICLON 865 (softening point of 64 to 72°C) (product name, manufactured by DIC Corporation) which is a modified novolac epoxy resin, and EPICLON N-685-EXP-S (softening point of 80 to 90°C) (product name, manufactured by Mitsubishi Chemical Corporation) which is a cresol novolac epoxy resin. Among these epoxy resins, the bisphenol A-type epoxy resin, the bisphenol F-type epoxy resin, the bisphenol AD-type epoxy resin, and the amine type epoxy resin having less ionic impurities and excellent reactivity are particularly preferable.

The epoxy resins described above are used alone as one kind, or in combination of two or more kinds.

In addition, in a case where the conductive adhesive composition contains the epoxy resins described above as the thermosetting resin, an epoxy compound having only one epoxy group in one molecular may be further contained as a reactive diluent. Such the epoxy compounds are available as commercially available products, and specific examples thereof include PGE (product name, manufactured by NIPPON KAYAKU Co., Ltd.), PP-101 (product name, manufactured by Tohto Kasei Co., Ltd.), ED-502, ED-509, and ED-509S (product names, manufactured by ADEKA CORPORATION), YED-122 (product name, manufactured by Yuka Shell Epoxy Co., Ltd.), KBM-403 (product name, manufactured by Shin-Etsu Chemical Co., Ltd.), and TSL-8350, TSL-8355, and TSL-9905 (product names, manufactured by Toshiba Silicones Co., Ltd.). These are used alone as one kind or in combination of two or more kinds.

A combination ratio of the reactive diluent may be in a range of not disturbing the effects of the present invention, and preferably 0 to 30% by mass with respect to the total amount of the epoxy resins.

In a case where the conductive adhesive composition contains the epoxy resins as the resin (B), it is further suitable to contain a curing agent or a curing accelerator thereof.

An example of the curing agent is not particularly limited as long as it is used, and the commercially available product can be used. Examples of the commercially available curing agent include H-1 (product name, manufactured by Meiwa Plastic Industries, Ltd.) and VR-9300 (product name, manufactured by Mitsui Chemicals, Inc.) which are phenol novolac resins, XL-225 (product name, manufactured by Mitsui Chemicals, Inc.) which is a phenol aralkyl resin, MTPC (product name, manufactured by Honshu Chemical Industry Co., Ltd.) which is p-cresol novolac resin represented by the following General Formula (I), AL-VR-9300 (product name, manufactured by Mitsui Chemicals, Inc.) which is an allylated phenol novolac resin, and PP-700-300 (product name, manufactured by Nippon Petrochemicals Co., Ltd.) which is a specialized phenol resin represented by the following General Formula (II).

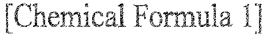

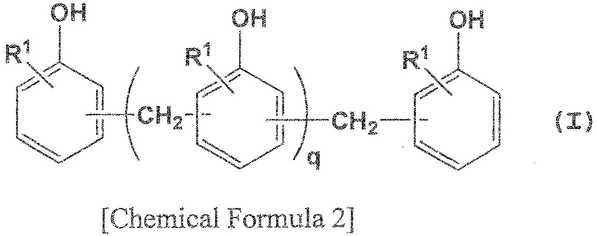

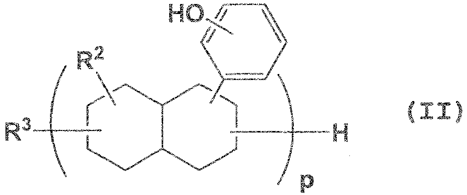

(In Formula (I), R¹ independently represents a monovalent hydrocarbon group, preferably, a methyl group or an aryl group, and q represents an integer from 1 to 5. In addition, in Formula (II), R² represents an alkyl group, preferably a methyl group or an ethyl group, R³ represents a hydrogen atom or a monovalent hydrocarbon group, and p represents an integer from 2 to 4.)

The combination rate of the curing agent is preferably a rate to have the total amount of the reaction activity group in the curing agent of equivalent amounts of 0.2 to 1.2, more preferably a rate to have the total amount thereof equivalent amounts of 0.4 to 1.0, and even more preferably a rate to have the total amount thereof equivalent amounts of 0.5 to 1.0, with respect to the equivalent amount of 1.0 of the epoxy group of the epoxy resin. If the amount of the reaction activity group is less than equivalent amount of 0.2, reflow crack resistance of the adhesive components tends to be decreased, and if the amount thereof exceeds equivalent amount of 1.2, the viscosity of the adhesive components tends to be increased and the workability tends to be decreased. The reaction activity group is a substituted group having reaction activity with the epoxy resin, and Examples thereof include a phenolic hydroxy group.

In addition, the curing accelerator is not particularly limited as long as it is conventionally used as a curing accelerator of the related art, such as dicyandiamide, and commercially available products can be used. Examples of the commercially available products include ADH, PDH, and SDH (product names, all manufactured by Japan Finechem Company, Inc.) which are dibasic acid dihydrazide represented by the following General Formula (III), and NOVACURE (product name, manufactured by Asahi Kasei Corporation) which is a microcapsule type curing agent consisting of a reactant of epoxy resins and amine compounds. These curing accelerators are used alone as one kind or in combination of two or more kinds. 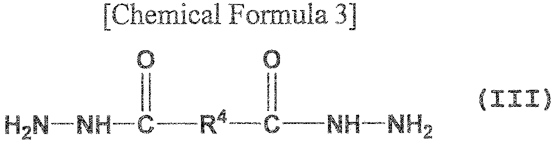 In Formula (III), R⁴ represents divalent aromatic group or a linear or branched alkylene group having 1 to 12 carbon atoms, preferably a m-phenylene group or a p-phenylene group.

The combination rate of the curing accelerator is preferably 0.01 to 90 parts by mass, and more preferably 0.1 to 50 parts by mass, with respect to 100 parts by mass of the epoxy resin. If the combination rate of the curing accelerator is less than 0.01 parts by mass, the curing property tends to be decreased, and if the combination rate thereof exceeds 90 parts by mass, the viscosity is increased, and workability at the time of using the adhesive components tends to be decreased.

In addition to or instead of the examples described above, as the commercially available curing accelerator, EMZ-K, and TPPK (product names, all manufactured by Hokko Chemical Industry Co., Ltd.) which are organic boron salt compounds, DBU, U-CAT 102, 106, 830, 840, and 5002 (product names, all manufactured by San-Apro Ltd.) which are tertiary amines or salts thereof, and CUREZOL, 2PZ-CN, 2P4MHZ, C17Z, 2PZ-OK, 2PZ-CNS, and C11Z-CNS (product names, all manufactured by Shikoku Chemicals Corporation) which are imidazoles, may be used.

The combination rate of these curing accelerator is preferably equal to or more than 0.1 parts by mass and equal to or less than 20 parts by mass, with respect to 100 parts by mass of the epoxy resin. The combination rate thereof is more preferably equal to or less than 15 parts by mass.

In addition, the curing agent and the curing accelerator may be used alone as one kind or in combination of two or more kinds, respectively.

Further, in addition to the thermosetting resins described above, thermoplastic resins which functions as a binder may be added to the conductive adhesive composition of the present invention. Examples of the thermoplastic resins include ABS resins (acrylonitrile, butadiene, and styrene copolymerization synthetic resins), polypropylene resins, polyethylene resins, polyvinyl chloride resins, polystyrene resins, polymethyl methacrylate resins, polybutadiene resins, polyethylene terephthalate resins, polyphenylene ether resins, nylon resins, polyamide resins, polycarbonate resins, polyacetal resin, polybutylene terephthalate resin, polyphenylene sulfide resins, polyether ether ketone resins, modified polyphenylene ether resins, liquid crystal polymers, fluorine resins, urethane resins, polyarylate resins, polyimide resins, polyamide imide resins, polyetherimide resins, polyether sulfone resins, and polysulfone resins. These thermoplastic resins are used alone as one kind or in combination of two or more kinds.

The content of the resin (B) of the conductive adhesive composition is preferably 1 to 60% by mass, more preferably 5 to 40% by mass, and even more preferably 10 to 30% by mass, with respect to the total amount of the adhesive components.

In addition to the resin (B), the conductive adhesive composition may contain one kinds or two or more kinds of resins which has a softening point higher than the melting point of the metal of the conductive particles (A) and/or is liquid at a room temperature. Examples of the resin having the softening point equal to or lower than the melting point of the metal of the conductive particles (A) include a polycarbonate resin, an acrylic resin, and a polyimide resin.

The flux activator (C) shows a function of removing an oxide film formed on the surfaces of the conductive particles (A). By using such flux activator, the oxide film which is disturbance of the melting and fusion of the conductive particles (A) is removed. The flux activator (C) is preferably a compound which does not disturb a curing reaction of the resin (B). Examples of the flux activator (C) include a rosin resin, a compound containing a carboxyl group, a phenolic hydroxy group, or an alcoholic hydroxy group in a molecule, dibasic acid having an alkyl group on a side chain such as 2,4-diethyl glutaric acid, 2,2-diethyl glutaric acid, 3-methyl glutaric acid, 2-ethyl-3-propyl glutaric acid, 2,5-diethyl adipic acid. Among them, since excellent flux activity is shown and excellent reactivity with the epoxy resin used as the resin (B) is shown, the compound containing a hydroxy group or a carboxyl group in a molecule is preferable and aliphatic dihydroxycarboxylic acid is particularly preferable. Specifically, a compound represented by the following General Formula (IV) or tartaric acid is preferable. 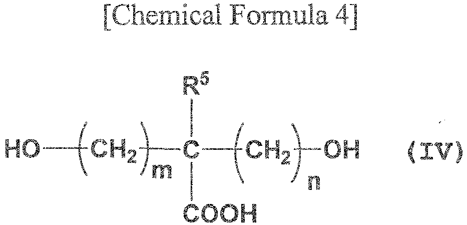 Herein, in Formula (IV), R⁵ represents an alkyl group having 1 to 5 carbon atoms, and from a viewpoint of further efficiently exhibiting the effects by using the compound represented by General Formula (IV), a methyl group, an ethyl group, or a propyl group is preferable. In addition, n and m independently represent an integer from 0 to 5, and from a viewpoint of further efficiently exhibiting the effects by using the compounds represented by General Formula (IV), it is preferable that n be 0 and m be 1, or both n and m be 1.

Examples of the compound represented by General Formula (IV) include 2,2-bis(hydroxymethyl)propionic acid, 2,2-bis(hydroxymethyl)butyric acid, and 2,2-bis(hydroxymethyl)pentanoic acid.

From a viewpoint of further efficiently exhibiting the effects of the present invention, the content of the flux activator (C) is preferably 0.1 to 30 parts by mass, with respect to 100 parts by mass of the total amount of the conductive particles (A). Further, from viewpoints of the preservation stability and the conductivity, the content thereof is more preferably 0.5 to 20 parts by mass, and even more preferably 1 to 10 parts by mass.

In a case where the content of the flux activator (C) is less than 0.1 parts by mass, a melting property of the metal of the conductive particles (A) tends to be decreased, and the conductivity tends to be decreased, and in a case where the content thereof exceeds 30 parts by mass, the preservation stability and the printing property tend to be decreased.

The solvent (D) is not particularly limited as long as it can perform viscosity adjustment for realizing more excellent workability at the time of producing the conductive adhesive composition and coating workability at the time of using it. Examples of such a solvent include water, methanol, ethanol, isopropyl alcohol, methylethylketone, methylisobutylketone, N-methyl-2-pyrrolidinone, diethylene glycol dimethyl ether (also called diglyme), triethylene glycol dimethyl ether (also called triglyme), diethylene glycol diethyl ether, 2-(2-methoxyethoxy) ethanol, γ-butyrolactone, isophorone, carbitol, carbitol acetate, 1,3-dimethyl-2-imidazolidinone, 2-(2-butoxyethoxy)ethyl acetate, ethylcellosolve, ethylcellosolve acetate, butylcellosolve, butylcellosolve acetate, dioxane, cyclohexane, cyclohexanone, anisole, butylcellosolve acetate, carbitol acetate, dipropylene glycol monomethyl ether, ethylene glycol diethyl ether, α-terpineol, and the like. These are used alone as one kind or in combination of two or more kinds. Among these, the solvent having a boiling point of 20 to 300°C is preferable and the solvent having a boiling point of 50 to 260°C is more preferable. The solvent having a boiling point of 80 to 220°C is particularly preferable. If the boiling point of the solvent is equal to or higher than 300°C, a working problem that removal of the solvent in the conductive adhesive composition in the drying step is difficult occurs, and if the boiling point of the solvent is equal to or lower than 20°C, it is difficult to evenly apply the conductive adhesive composition onto the electrode surfaces of the solar battery cells. As the solvent having the preferable boiling point, diglyme (boiling point of 162°C), triglyme (boiling point of 216°C), butyl cellosolve (boiling point of 171°C), and the like are preferable, for example. These solvents are used alone as one kind, or in combination of two or more kinds.

1.0 to 95% by mass of the solvent (D) is preferably contained with respect to the total amount of the conductive adhesive composition. Further, 1 to 50% by mass thereof is more preferably contained, and 5 to 30% by mass thereof is particularly preferably contained. Furthermore, 5 to 20% by mass thereof is particularly preferably contained. If the amount of solvent is equal to or less than 0.1% by mass, the viscosity is increased and the workability in the coating step is degraded. In addition, if the amount of solvent exceeds 95% by mass, it is not possible to sufficiently apply the conductive particle components, and there is a problem that more time is required for drying.

In order to improve adhesiveness, the conductive adhesive composition may contain a coupling agent such as a silane coupling agent or a titanium coupling agent. Examples of the silane coupling agent include "KBM-573" which is a product name, manufactured by Shin-Etsu Chemical Co., Ltd.. In addition, in order to improve wettability, an anionic surfactant or fluorine surfactant may be contained in the adhesive components. Further, silicone oil or the like may be contained as a defoamer. The adhesive improving agent, the wettability improving agent, and defoamer are used alone as one kind or in combination of two or more kinds. 0.1 to 10% by mass of these is preferably contained, respectively with respect to the total amounts of the components other than the solvent of the conductive adhesive composition.

The conductive adhesive composition may contain filler. Examples of the filler include polymer particles such as acrylic rubber or polystyrene, and inorganic particles such as diamond, boron nitride, aluminum nitride, alumina, and silica. These filler may be used alone as one kind or in combination or two or more kinds.

In addition to the respective components described above, the conductive adhesive composition may contain one kind or more additives selected from a group consisting of a flexibility imparting agent for reaction alleviation, diluents for improving the workability, an adhesiveness improving agent, a wettability improving agent, and defoamer, if necessary. In addition to these components, various additives may be contained in a range of not disturbing the effects of the present invention.

Examples of the flexibility imparting agent include liquid polybutadiene ("CTBN-1300X31" and "CTBN-1300X9" which are product names manufactured by Ube industries, Ltd. and "NISSO-PB-C-2000" which is a product name manufactured by Nippon Soda Co., Ltd.). In a case of containing the flexibility imparting agent, in general, the content thereof is preferably 0.01 to 500 parts by mass, with respect to 100 parts by mass of the total amount of the thermosetting resin.

In the embodiment, from a viewpoint of more efficiently exhibiting the effects, the combination ratio of the adhesive component (adhesive component / conductive particles) is preferably 5/95 to 50/50 with respect to the solid content ratio (mass ratio) in the conductive adhesive composition. Further, from viewpoints of adhesiveness, conductivity, and workability, the combination ratio is more preferably 10/90 to 30/70. If this combination ratio is less than 5/95, the viscosity of the adhesive component is increased and thus, the workability is difficult to be secured, or the adhesiveness tends to be decreased. If this combination ratio exceeds 50/50, the conductivity tends to be decreased.

In the present embodiment, any of the exemplified respective components described above may be combined to each other.

Since the conductive adhesive composition of the present invention contains the solvent (D), it is generally a liquid conductive adhesive composition.

By performing mixing, dissolving, kneading or dispersing of each component described above at one time or at plural times, and heating if necessary, the conductive adhesive composition described above is obtained as a paste-like composition in which each component is evenly dispersed. Examples of a device for dispersing and dissolving used at this time include a well-known stirrer, a Raikai mixer, a triple roller, a planetary mixer, or the like is used.

According to the conductive adhesive composition according to the embodiment described above, it is possible to provide a conductive adhesive composition which does not have tackiness at a room temperature and is capable of electrical connection at a low temperature. In addition, by using the conductive adhesive composition, it is possible to provide a connected body which realizes shortening and simplicity of process at the time of producing the solar cell module. Further, by using the conductive adhesive composition of the embodiment which is capable of electrical connection at a low temperature, it is possible to provide a solar cell module having high reliability.

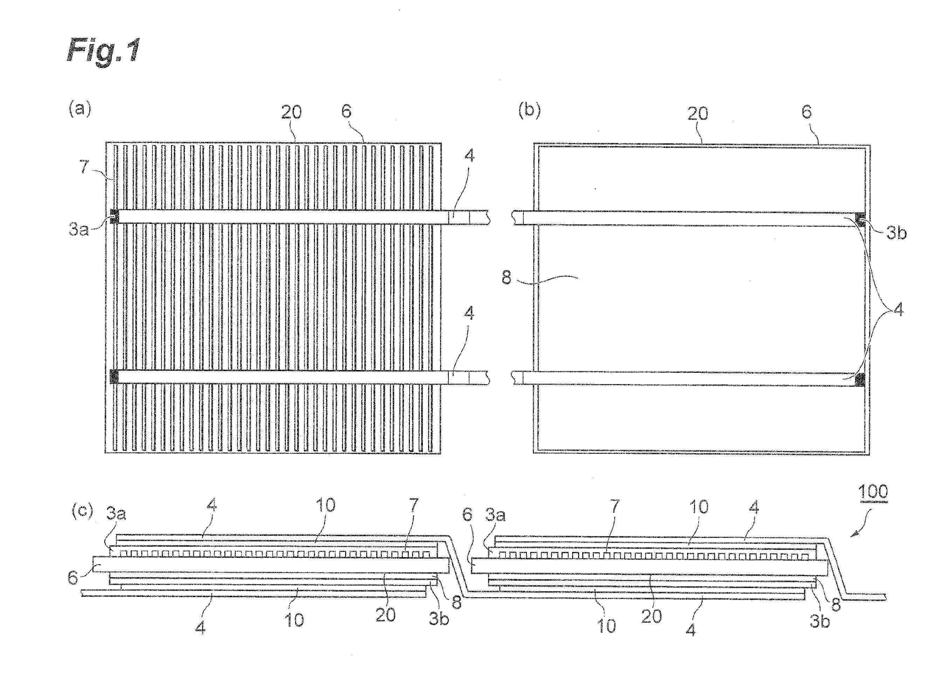

Next, an example of the solar cell module manufactured using the conductive adhesive composition of the embodiment will be described with reference to Fig. 1.

Fig. 1 is a schematic view showing main parts of the solar cell module, and shows an outline of a structure in which the plurality of solar battery cells are connected to each other by wires, as an example. Fig. 1(a) shows a front surface side of the solar cell module, Fig. 1(b) shows a rear surface side, and Fig. 1(c) shows a side surface side.

As shown in Figs. 1(a) to 1(c), in a solar cell module 100, a plurality of solar battery cells 20 in which each of, a grid electrode 7 and a bus electrode (surface electrode) 3a are formed on a front surface side of a semiconductor wafer 6, and a rear surface electrode 8 and a bus electrode (surface electrode) 3b are formed on a rear surface side thereof, are connected to each other by metal wires 4. One end and the other end of the metal wires 4 are electrically connected to the bus electrode 3a as a surface electrode and the bus electrode 3b as a surface electrode respectively, via the conductive adhesive composition 10 of the embodiment.

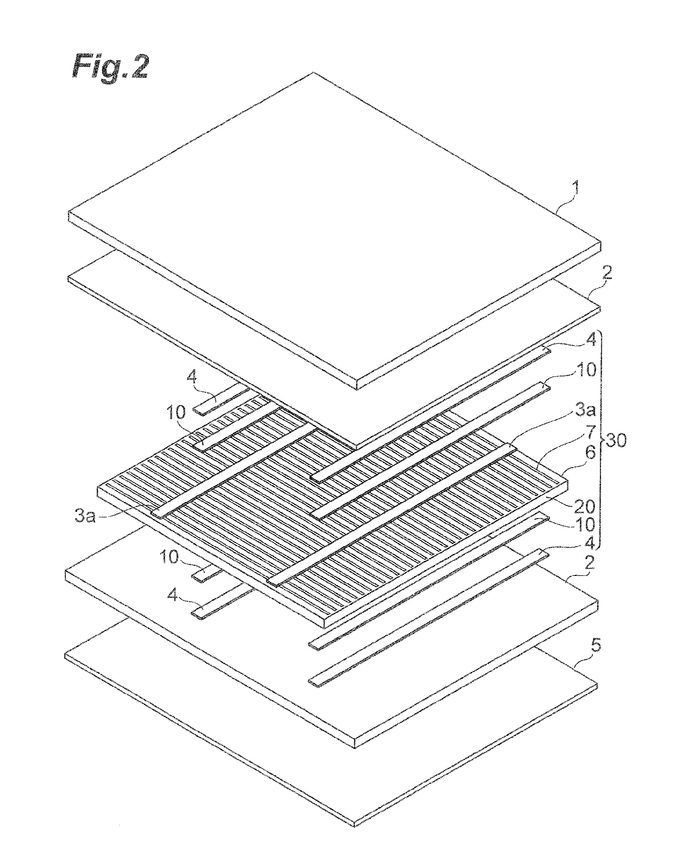

Fig. 2 is a view for illustrating one embodiment of a method for producing the solar cell module of the embodiment.

For example, the solar cell module of the embodiment is manufactured by a production method including: a step of disposing the metal wires 4 and the bus electrodes 3a and 3b so as to face to each other via the conductive adhesive composition 10 to produce a connected body 30; a step of laminating the sealing material 2 onto both surfaces of the connected body 30; a step of laminating glass 1 on the sealing material 2 on a light-receiving surface side of the solar battery cell 20, and a back sheet 5 (protection film) on the sealing material 2 on a rear surface side of the solar battery cell 20, and a step of performing heating pressure bonding of the obtained laminated body with a pressure of 0.1 to 6 MPa at a temperature of 140 to 210°C (preferably at a temperature equal to or higher than the melting point of the conductive particles (A)) for 1 to 30 minutes. In this step of heating pressure bonding, the electrical connection and the bonding by the curing of the thermosetting resin between the bus electrodes 3a and 3b of the solar battery cells 20 and the metal wires 4 are performed, and at the same time, the sealing of the solar battery cells 20 is performed, and thus, the solar cell module can be collectively manufactured.

According to the method, it is possible to realize low cost by the shortening of the steps and improvement of productivity compared to the conventional steps.

As a method of interposing the conductive adhesive composition between the bus electrode 3a or 3b and the metal wire 4, a method of applying the conductive adhesive composition 10 on the bus electrodes 3a and 3b or the metal wire 4 by a dispensing method, a screen printing method, and a stamping method, is used, for example. After that, by disposing the metal wire 4 and the bus electrodes 3a and 3b so as to face to each other via the conductive adhesive composition 10, the connected body 30 can be obtained.

Other than these manufacturing method, after disposing the metal wire 4 and the bus electrodes 3a and 3b of the solar battery cells so as to face to each other via the conductive adhesive composition 10, preliminary pressure bonding in which the electrical connection of the bus electrodes 3a and 3b of the solar battery cells and the metal wires 4 is conducted by performing heating pressure bonding with pressure of 0.1 to 6.0 MPa at a temperature of 140 to 210°C (preferably a temperature equal to or higher than the melting point of the conductive particles (A)) for 1 to 30 minutes may be performed. By performing the preliminary pressure bonding, since the connection of the solar battery cells 20 and the metal wires 4 is performed, it is easy to handle the connected body 30 and the workability at the time of manufacturing the solar cell module is improved.

In a case of performing the preliminary pressure bonding, the sealing materials 2 are disposed on both surfaces of the obtained connected body 30, the glass 1 is disposed on the sealing material 2 on a light-receiving surface side of the solar battery cell 20, a back sheet 5 (protection film) is disposed on the sealing material 2 on a rear surface side of the solar battery cell 20, the obtained laminated body is subject to heating pressure bonding with pressure of 0.1 to 6 MPa at a temperature of 140 to 180°C for 1 to 30 minutes to seal the solar battery cells, and thus, the solar cell module can be manufactured.

Examples of the glass 1 include dimpled whiteboard-reinforced glass for solar battery cells. Examples of the sealing material 2 include ethylene-vinyl acetate copolymer resins (EVA) or sealing resins using polyvinylbutyral. Examples of the metal wires 4 include TAB lines obtained by performing dipping or plating of solder to a Cu line. Examples of the back sheet 5 include PET-based or Tedlar-PET laminated material, metal foil-PET laminated material.

Even in a case of using the circuit substrate in which a metal wire is formed on a plastic substrate, the conductive adhesive composition of the embodiment can perform connection with the electrodes of the solar battery cells in the steps described above. In addition, even in a case of using a film-like circuit substrate, the connection with the electrodes of the solar battery cells can be performed in the same steps as described above using the conductive adhesive composition of the embodiment.

The cured product of the conductive adhesive composition of the embodiment can be used as a conductive layer which bonds and electrically connects a substrate, an electronic component, and the substrate and the electronic component. In addition, the cured product thereof can also be used as a conductive layer which bonds and electrically connects a support base material for semiconductor mounting, a semiconductor element, and the support base material and the semiconductor element.

In addition, the conductive adhesive composition of the embodiment can also be used for the connection of the electrodes of the rear surface electrode-type (back contact-type) solar battery cells and the wiring members. In this case, first, the conductive adhesive composition of the embodiment is applied onto the electrodes of the circuit substrates or onto the rear surface electrodes of the solar battery cells. Then, the sealing material obtained by gouging the electrode portion (applied portion of the conductive adhesive composition) of the circuit substrate out is laminated on the circuit substrate, the solar battery cells are disposed thereon so that the rear surface electrodes of the solar battery cells and the electrode portions of the circuit substrates are connected via the conductive adhesive composition. Further, the sealing materials and glass are disposed on the light-receiving surfaces of the solar battery cells, the back sheets are disposed on the rear surface side of the solar battery cells, and heating pressure bonding of this solar cell module is performed, and thus, connection and bonding of the rear surface electrodes of the solar battery cells and the electrodes of the circuit substrates, and the sealing step of the solar battery cells can be collectively performed. As the glass and sealing materials, the examples used in the method for producing the solar cell module can be used.

The metal wire with a conductive adhesive of the embodiment is formed of a metal wire and an adhesive layer obtained by coating of the metal wire. The adhesive layer is formed from an adhesive using the conductive adhesive composition described above.

The material of the metal wire is not particularly limited. The material having low specific resistance and having mechanical strength is particularly desirable, and example thereof include copper, aluminum, gold, or the like. In addition, the material may be obtained by vapor deposition or plating process of the metal layer such as gold, silver, palladium, nickel, tin, solder, and the like, and surface treatment of acid treatment or the like may also be executed.

Examples of a method of coating the metal wire with the adhesive layer include a method of applying the conductive adhesive composition onto the metal wire.

Examples of a method of applying the conductive adhesive composition onto the metal wire include screen printing, stencil printing, a dispenser, a spray method, immersion, and the like. Examples of a method of drying the metal wire after the applying include vacuum drying or heating at a temperature equal to or lower than the curing temperature of the curing component. The drying temperature range by the heating is necessary to be suitably determined by the curing temperature of the solvent or the curing component. In a case of low temperature, evaporation of the solvent component is delayed and sufficient drying is not performed, and this causes peeling-off at the time of use. In addition, in a case of higher drying temperature than the curing temperature, curing of the curing component starts, and fluidity of the conductive particles (A) is decreased, and thus, fusion cannot be performed.

The metal wire with a conductive adhesive of the embodiment can be suitably used for electrical connection of the plurality of solar battery cells.

In a case of using the metal wire with a conductive adhesive, a solar cell module can be produced by the same producing method as the method using the conductive adhesive composition 10, except for the different producing method of the connected body 30. In a case of using the metal wire with a conductive adhesive, a connected body can be obtained by disposing and connecting the metal wire with a conductive adhesive onto the bus electrodes 3a and 3b.

Examples of a connecting method of the bus electrodes 3a and 3b and the metal wire with a conductive adhesive include a method of heating at a temperature of 140 to 180°C for 1 to 30 minutes. Examples

Hereinafter, the present invention will be described in more detail with Examples, however, the present invention is not limited to Examples. In addition, the materials used in Examples and Comparative Examples are manufactured in the method described below or purchased. One example of the producing method is shown in Example 1, resin composition and combination ratios of the other Examples and Comparative Examples are as shown in Table 1, and the producing methods thereof are in the same manner as Example 1.

### [Example 1]

12.0 parts by mass of Epikote 1007 (product name of bisphenol A-type epoxy resin, manufactured by Mitsubishi Chemical Corporation: softening point of 128°C), 0.5 parts by mass of 2P4MHZ-PW (product name of 2-phenyl-4-methyl-5-hidroxymethylimidazole, manufactured by Shikoku Chemicals Corporation), 1.5 parts by mass of BHPA (2,2-bis(hydroxymethyl)propionic acid), and 12.0 parts by mass of butyl cellosolve were mixed, and were passed through a triple roller three times, to produce an adhesive component.

Then, 74 parts by mass of Sn42-Bi58 particles (average particle size of 20 µm, melting point: 138°C) which are conductive particles were added and mixed with respect to 26 parts by mass of the adhesive component described above. Further, after passing the triple roller through the mixture thereof three times, a defoaming process was performed at equal to or less than 500 Pa for 10 minutes by using a vacuum stirring Raikai mixer to obtain a conductive adhesive composition.

### [Examples 2 and 3 and Comparative Example 1]

As described above, conductive adhesive compositions of Examples 2 and 3 and Comparative Example 1 were obtained in the same manner as Example 1 except for composition shown in Table 1.
Further, the unit of the combination rates of each material in Table 1 is parts by mass.
YD-014: bisphenol A-type epoxy resin manufactured by NIPPON STEEL & SUMIKIN CHEMICAL CO., LTD.: softening point of 91°C to 102°C
YL983U: bisphenol F-type epoxy resin manufactured by Mitsubishi Chemical Corporation: liquid resin at a room temperature Sn42-Bi57-Ag1 solder: melting point of 139°C

**[Table 1]**

| Items | | Example 1 | Example 2 | Example 3 | Comparative Example 1 |
|---|---|---|---|---|---|
| Thermosetting resin | Epikote 1007 | 12.0 | - | 12.0 | - |
| | YD-014 | - | 12.0 | - | - |
| | YL983U | - | - | - | 12.0 |
| Curing accelerator | 2P4MHZ-PW | 0.5 | 0.5 | 0.5 | 0.5 |
| Flux activator | BHPA | 1.5 | 1.5 | 1.5 | 1.5 |
| Solvent | Butyl cellosolve | 12.0 | 12.0 | 12.0 | - |
| Conductive particles | Sn42-Bi58 | 74 | 74 | - | 74 |
| | Sn42-Bi57-Ag1 | - | - | 74 | - |

### (Producing of coated cell)

The conductive adhesive compositions obtained in Examples 1 to 3 and Comparative Example 1 were printed onto the surface electrodes (material: silver glass paste, 2 mm x 125 mm) formed on the light-receiving surfaces of the solar battery cells (125 mm x 125 mm, thickness of 310 µm) by using a metal mask (thickness of 100 µm, opening dimension of 1.2 mm x 125 mm), were dried on a hot plate at 100°C for 3 minutes, and a coated cell was produced.

### [Comparative Example 2]

In the same manner as described above, the Sn96.5-Ag3.0-Cu0.5 solder was printed onto the surface electrodes formed on the light-receiving surfaces of the solar battery cell, was dried at 100°C for 3 minutes, and a coated cell was produced.

### (Evaluation of Coated Cell)

The tackiness, the conductivity, and fusion of the conductive particles of coated cells of Examples 1 to 3 and Comparative Examples 1 and 2 were evaluated under the following conditions. The results thereof were collectively shown in Table 2.

When coated tab line ("A-TPS", product name, manufactured by Hitachi Cable, Ltd.) was overlapped on the coated surface and lifted up, in a case where the tab line was separated, it was determined that the tackiness of the coated cell was not obtained, and in a case where the tab line was still attached thereto, it was determined that the tackiness thereof was obtained.
For the adhesiveness, solder-coated tab line ("A-TPS", product name, manufactured by Hitachi Cable, Ltd.) was disposed onto the conductive adhesive composition formed on the light-receiving surface of the coated cell as a metal wire, was heated on a hot plate at 160°C for 10 minutes, and electrical connection of the metal wire was checked. The measurement was performed using a solar simulator ("WXS-155S-10: product name, manufactured by Wacom Electric Co., Ltd., AM: 1.5G).
The fusion state of the conductive particles was checked by an X-ray inspection system (SMX-1000, micro focus X-ray inspection system manufactured by Shimadzu Corporation).

**[Table 2]**

| Evaluation of coated cell | Example 1 | Example 2 | Example 3 | Comparative Example 1 | Comparative Example 2 |
|---|---|---|---|---|---|
| Tackiness | No tackiness | No tackiness | No tackiness | Tackiness obtained | No tackiness |
| connectivity | Connected | Connected | Connected | Connected | Not connected |
| Fusion of conductive particles | Fusion | Fusion | Fusion | Fusion | - |

### (Metal wire with a conductive adhesive)

The conductive adhesive compositions obtained in Examples 1 to 3 and Comparative Example 1 were applied onto the coated tab line ("A-TPS", product name, manufactured by Hitachi Cable, Ltd.) to have a width of 400 mµ and a thickness of 200 µm, and was heated on a hot plate at 100°C for 3 minutes, and metal wires with a conductive adhesive was produced.

### (Evaluation of metal wire with a conductive adhesive)

For the metal wires with a conductive adhesive of Examples 1 to 3 and Comparative Example 1, the tackiness, the adhesiveness, and the fusion of the conductive particles were evaluated under the following conditions. The results thereof were collectively shown in Table 3.

For the tackiness of the metal wires with a conductive adhesive, when coated tab line ("A-TPS", product name, manufactured by Hitachi Cable, Ltd.) was overlapped on the coating surface and lifted up, in a case where the tab line was separated, it was determined that the tackiness of the coated cell was not obtained, and in a case where the tab line was still attached thereto, it was determined that the tackiness thereof was obtained.
For the adhesiveness, the metal wires with a conductive adhesive was disposed on the surface electrodes (material: silver glass paste, 2 mm x 125 mm) formed on the light-receiving surfaces of the solar battery cells (125 mm x 125 mm, thickness of 310 µm), and was heated on a hot plate at 160°C for 10 minutes, and electrical bonding of the metal wires were checked. The determination was performed using a solar simulator ("WXS-155S-10: product name, manufactured by Wacom Electric Co., Ltd., AM: 1.5G).
The fusion state of the conductive particles was checked by the X-ray inspection system (SMX-1000, micro focus X-ray inspection system manufactured by Shimadzu Corporation).

### [Comparative Example 3]

After applying a flux activator ("Deltalux 533", product name, manufactured by Senju Metal Industry Co., Ltd.) onto the surface electrodes on the light-receiving surfaces and the rear surfaces of the solar battery cells, the Sn96.5-Ag3.0-Cu0.5 solder (melting point of 217°C) coated tab line ("A-TPS", product name, manufactured by Hitachi Cable, Ltd.) was disposed, and was heated on a hot plate at 160°C for 10 minutes, and the electrical bonding of the metal wires were checked. The determination was performed using a solar simulator ("WXS-155S-10: product name, manufactured by Wacom Electric Co., Ltd., AM: 1.5G). The results thereof are shown in Table 3.

**[Table 3]**

| Evaluation of metal wire with an adhesive | Example 1 | Example 2 | Example 3 | Comparative Example 1 | Comparative Example 3 |
|---|---|---|---|---|---|
| Tackiness | No tackiness | No tackiness | No tackiness | Tackiness obtained | No tackiness |
| connectivity | Connected | Connected | Connected | Connected | connection not obtained |
| Fusion of conductive particles | Fusion | Fusion | Fusion | Fusion | - |

All of the coated cells and the metal wires with a conductive adhesive of Examples 1 to 3 had no tackiness and had excellent handling properties. In addition, they were also connected to the solar battery cells by heating at 160°C for 10 minutes, and the fusion of the conductive particles was checked. On the other hand, tackiness remained in the coated cell and the metal wires with a conductive adhesive of Comparative Example 1, and thus there was a problem of a handling property. The coated cell of Comparative Example 2 and the metal wires with a conductive adhesive of Comparative Example 3 were not connected to the solar battery cells at 160°C for 10 minutes, and it was checked that the adhesiveness at a low temperature was degraded.

### Reference Signs List

1: Glass, 2: Sealing material, 3a, 3b: Bus electrodes, 4: Metal wire, 5: Back sheet, 6: Semiconductor wafer, 7: Grid electrode, 8: Rear surface electrode, 10: Conductive adhesive composition, 20: Solar battery cell, 100: Solar cell module

## Claims

1. A conductive adhesive composition comprising: conductive particles (A) containing metal having a melting point of equal to or lower than 210°C; a resin (B) having a softening point of equal to or lower than the melting point of the metal of the conductive particles and being solid at a room temperature; a flux activator (C); and a solvent (D).

2. The conductive adhesive composition according to claim 1, wherein the metal of the conductive particles (A) contains at least one component selected from bismuth, indium, tin, and zinc.

3. The conductive adhesive composition according to claim 1 or 2, wherein the resin (B) contains a thermosetting resin.

4. The conductive adhesive composition according to claim 3, wherein the thermosetting resin is an epoxy resin.

5. The conductive adhesive composition according to claim 3 or 4, further containing a curing agent or a curing accelerator.

6. The conductive adhesive composition according to any one of claims 1 to 5, wherein the flux activator (C) contains a compound having a hydroxy group and a carboxyl group.

7. The conductive adhesive composition according to any one of claims 1 to 6, wherein a boiling point of the solvent (D) is equal to or higher than 20°C and equal to or lower than 300°C.

8. The conductive adhesive composition according to any one of claims 1 to 7, being used for electrical connection of electrodes of solar battery cells and a metal wire.

9. A connected body in which a plurality of solar battery cells are connected via a metal wire,
wherein electrodes of the solar battery cells and the metal wire are connected via the conductive adhesive composition according to any one of claims 1 to 8.

10. A metal wire with a conductive adhesive formed of a metal wire and an adhesive layer coating the metal wire,
wherein the adhesive layer is formed of an adhesive using the conductive adhesive composition according to any one of claims 1 to 8.

11. A connected body formed of a plurality of solar battery cells, and a metal wire with a conductive adhesive which is disposed on electrode surfaces of the solar battery cells and is for electrical connection of the plurality of solar battery cells,
wherein the metal wire with a conductive adhesive is the metal wire with a conductive adhesive according to claim 10.

12. A method for producing a solar cell module comprising:
a step of laminating a sealing material on both surfaces of the connected body according to claim 9 or 11;
a step of laminating glass on the sealing material on a light receiving surface side of the solar battery cells, and a protection film on the sealing material on a rear surface of the solar battery cells; and
a step of sealing the solar battery cells while electrically connecting and bonding the solar battery cells and the metal wires by heating the obtained laminated body.

13. A solar cell module in which electrodes of a plurality of solar battery cells and a metal wire are electrically connected via the conductive adhesive composition according to any one of claims 1 to 8.
